# EUROPÄISCHE PATENTSCHRIFT

(11) **EP 0 745 704 B1**
(45) Veröffentlichungstag und Bekanntmachung des Hinweises auf die Patenterteilung: **25.08.1999**
(21) Anmeldenummer: 96108627.9
(22) Anmeldetag: 30.05.1996
(51) Int. Cl.: C30B 13/00, C30B 29/06, C30B 13/12

(54) **Verfahren zur Herstellung einer epitaktisch beschichteten Halbleiterscheibe**
Process for preparing an epitaxially coated semiconducting wafer
Procédé pour la préparation d'une plaquette de semi-conducteur avec film épitaxial

(30) Priorität: 01.06.1995 DE 19520175
(43) Veröffentlichungstag der Anmeldung: 04.12.1996
(73) Patentinhaber: Wacker Siltronic Gesellschaft für Halbleitermaterialien Aktiengesellschaft, 84489 Burghausen (DE)
(72) Erfinder: Siebert, Wolfgang, Dr., 84556 Kastl (DE); Mayer, Erwin-Peter, Dr., 84489 Burghausen (DE)
(74) Vertreter: Schuderer, Michael, Dr.

(56) Entgegenhaltungen:
- EP-A- 0 054 657
- EP-A- 0 504 929
- DE-A- 4 119 531
- FR-A- 1 399 130
- US-A- 5 089 082
- PATENT ABSTRACTS OF JAPAN vol. 11, no. 27 (E-474), 27.Januar 1987 & JP-A-61 198638 (SONY CORP.)

## Beschreibung

Die Erfindung betrifft ein Verfahren zur Herstellung einer epitaktisch beschichteten Halbleiterscheibe, bestehend aus einer Substratscheibe aus monokristallinem Silicium mit einer Vorder- und einer Rückseite und mindestens einer Schicht aus Halbleitermaterial, die auf der Vorderseite der Substratscheibe epitaktisch abgeschieden ist. Die Erfindung betrifft auch eine Halbleiterscheibe, die nach dem Verfahren erhältlich ist.

Epitaktisch beschichtete Halbleiterscheiben und deren Herstellung sind beispielsweise in der DE-41 19 531 A1 beschrieben. Die Herstellung umfaßt das Abscheiden epitaktischer Schichten auf Substratscheiben, die von einem Einkristallstab abgetrennt wurden, der nach dem sogenannten Czochralski-Verfahren aus einer in einem Quarztiegel gehaltenen Schmelze gezogen wurde. Diese Einkristalle und die daraus gewonnenen Substratscheiben, die nachfolgend CZ-Einkristalle beziehungsweise CZ-Substratscheiben genannt werden, sind mit vom Tiegelmaterial stammendem Sauerstoff verunreinigt. Die Verunreinigung mit Sauerstoff wird genutzt, indem durch thermische Behandlung der Substratscheiben Sauerstoff-Präzipitate erzeugt werden, die als sogenannte interne Getter wirken und insbesondere metallische Verunreinigungen an sich binden. Auf diese Weise kann die auf der Substratscheibe epitaktisch abgeschiedene Schicht weitgehend frei von metallischen Verunreinigungen gehalten werden. Dies ist besonders wichtig, da in diesem Bereich der Halbleiterscheibe elektronische Strukturen und Bauelemente vorgesehen sind, deren Funktionstüchtigkeit durch Fremdmetallatome erheblich gestört wird.

Die Herstellung von stark dotierten CZ-Einkristallen mit niedrigem spezifischen Widerstand ist allerdings recht teuer und insbesondere bei Dotierung mit Phosphor auch technisch problematisch. Insbesondere ist es verfahrensbedingt nicht möglich, einen gleichmäßig stark mit Phosphor dotierten CZ-Einkristall herzustellen. In der Regel ist es nämlich nicht zu vermeiden, daß die Dotierstoff-Konzentration im Einkristall axial ab- und der spezifische Widerstand zunimmt. Aus diesem Grund sind ein Teil der aus dem Einkristall hergestellten CZ-Substratscheiben als stark dotierte Substratscheiben nicht zu verwenden. Dieser Ausbeuteverlust wirkt sich natürlich auch nachteilig auf den Preis aus, der für epitaktisch beschichtete Halbleiterscheiben zu zahlen ist, die auf stark dotierten CZ-Substratscheiben basieren.

Die Aufgabe der Erfindung bestand darin, eine epitaktisch beschichtete Halbleiterscheibe mit stark dotierter Substratscheibe bereitzustellen, die kostengünstig in der Herstellung ist und gegenüber bekannten Halbleiterscheiben dieser Gattung auch technische Vorteile aufweist.

Gelöst wird die Aufgabe durch ein Verfahren zur Herstellung von Halbleiterscheiben der genannten Gattung, das durch die folgenden Verfahrensschritte gekennzeichnet ist:
a) Herstellen eines stark dotierten Einkristalls aus Silicium durch tiegelfreies Zonenziehen;
b) Herstellen einer Substratscheibe mit polierter Vorderseite aus dem Einkristall;
c) Abscheiden von mindestens einer epitaktischen Schicht aus Halbleitermaterial auf der Vorderseite der Substratscheibe.

Erfindungsgemäß werden die Substratscheiben von Einkristallen gewonnen, die durch tiegelfreies Zonenziehen (Float-Zoning-Verfahren) hergestellt worden sind. Wegen dieser Herkunft werden nachfolgend die Begriffe FZ-Substratscheiben, beziehungsweise FZ-Einkristalle verwendet. Die Dotierstoff-Konzentration in stark dotierten FZ-Einkristallen bleibt über die gesammte Stablänge nahezu konstant, so daß sich die daraus gewonnenen FZ-Substratscheiben in bezug auf ihren spezifischen Widerstand nicht wesentlich unterscheiden. Darüber hinaus ermöglicht das FZ-Verfahren insbesondere auch die Herstellung von stark mit Phosphor dotierten Einkristallen mit einer Dotierstoff-Konzentration, die bei CZ-Einkristallen unter normalen Herstellungsbedingungen nicht zu erreichen ist.

Die nach dem Verfahren hergestellten, epitaktisch beschichteten FZ-Substratscheiben eignen sich besonders als Grundmaterial zur Herstellung integrierter, elektronischer Bauelemente für sogenannte Power-MOS Anwendungen, beispielsweise zur Herstellung von Leistungsschaltern, hochsperrenden Dioden und Schottky-Dioden, da die Zahl solcher pro Flächeneinheit auf der Halbleiterscheibe integrierbarer, elektronischer Bauelemente entscheidend vom Widerstand der Substratscheibe abhängt. Je höher die Dotierstoff-Konzentration in der Substratscheibe ist, desto geringer ist beispielsweise die für einen Leistungsschalter benötigte Fläche auf der Halbleiterscheibe. Darüber hinaus sind die Halbleiterscheiben auch als Grundmaterial zur Herstellung integrierter, elektronischer Bauelemente für sogenannte CMOS-Anwendungen geeignet, ebenso wie zur Herstellung diskreter, elektronischer Bauelemente.

Die Herstellung der Halbleiterscheiben gemäß der Erfindung umfaßt zunächst das Ziehen eines stark dotierten Einkristalls aus Silicium nach dem an sich bekannten FZ-Verfahren, das beispielsweise in einem Übersichtsartikel von W.Dietze näher beschrieben ist (W.Dietze et al., Crystals, Growth, Properties and Applications, Vol.5, Springer-Verlag 1981, S.1-42). Die Dotierung des Einkristalls erfolgt während des Ziehens des Einkristalls mit Bor oder einem Dotierstoff der 5. Hauptgruppe des Periodensystems, vorzugsweise mit Phosphor. Besonders bevorzugt ist, eine gasförmige Verbindung des Phosphors bereitzustellen, die sich beim Kontakt mit der heißen Schmelzzone aus Silicium zersetzt, wobei Phosphor in das schmelzflüssige Silicium aufgenommen wird. Die Dotierungs-Bedingungen werden so eingestellt, daß die Dotierstoff-Konzentration im Einkristall größer als 1,5∗10¹⁸ at/cm³ ist. Im Sinne der Erfindung wird der Einkristall und eine von diesem abgetrennte Substratscheibe als stark dotiert bezeichnet, wenn die Dotierstoff-Konzentration über diesem Grenzwert liegt.

Eine Weiterbildung der Erfindung sieht vor, während des Ziehens des Einkristalls Sauerstoff als weitere Verunreinigung in das Kristallgitter einzubringen. Ein Verfahren, das dafür geeignet ist, ist in der US-5,089,082 beschrieben. Die Sauerstoff-Konzentration im Einkristall beträgt 1∗10¹⁶ bis 8∗10¹⁷ at/cm³, vorzugsweise 4∗10¹⁷ bis 5∗10¹⁷ at/cm³. Durch den zusätzlichen Einbau von Sauerstoff können in den Substratscheiben als interne Getter wirkende Sauerstoff-Präzipitate erzeugt werden. Außerdem wird durch den Einbau von Sauerstoff in das Kristallgitter die von S.M.Hu bei FZ-Substratscheiben festgestellte Neigung zur Ausbildung von Versetzungen reduziert (S.M.Hu, Appl.Phys.Lett. **31** (1977), 53).

Der fertiggestellte FZ-Einkristall wird in bekannter Weise, beispielsweise mit Hilfe einer Innenlochsäge, in eine Vielzahl von Substratscheiben geteilt. Bevor auf einer Seite einer Substratscheibe eine epitaktische Schicht abgeschieden wird, wird die Substratscheibe chemischen und/oder mechanischen Oberflächenbehandlungen unterzogen. Zu diesen Oberflächenbehandlungen gehören die auf diesem technischen Gebiet üblichen Läpp-, Polier- und Ätzbehandlungen, auf die nicht näher eingegangen werden muß. Die Vorderseite der Substratscheibe, auf der mindestens eine Schicht aus Halbleitermaterial epitaktisch abzuscheiden vorgesehen ist, wird hochglanzpoliert. Darüber hinaus kann gegebenenfalls die Rückseite der Substratscheibe mit einer Schicht aus polykristallinem Silicium und/oder Siliciumdioxid beschichtet sein, wobei erstere als sogenannter externer Getter in der Lage ist, metallische Verunreinigungen aus dem Einkristall aufzusaugen. Das Aufbringen von Schichten, die als externer Getter wirken, auf die Rückseite von Halbleiterscheiben ist ebenfalls bekannt und wird daher nicht näher erläutert.

Auf der polierten Vorderseite der Substratscheibe wird mindestens eine Schicht aus Halbleitermaterial, vorzugsweise aus Silicium, epitaktisch abgeschieden. Die Abscheidung von Halbleiterschichten auf Substrat scheiben ist bekannt und beispielsweise in der DE-41 19 531 A1 beschrieben. Die Beschichtung der Substratscheibe erfolgt in einem Epitaxie-Reaktor, in den in einer bestimmten Abfolge von Prozeßschritten verschiedene Prozeßgase eingeleitet werden. Die Art des verwendeten Reaktors (Einzelscheiben- oder Batchreaktor), die Art der verwendeten Abscheide-, Dotier-, Träger- und Spülgase und das Abscheideprotokoll, das heißt, die Dauer der Behandlung, die Abfolge der Prozeßschritte, sowie Temperatur- und Druckverhältnisse während der Behandlung und die Abscheideraten sind im Zusammenhang mit der vorliegenden Erfindung nicht wesentlich. Im Prinzip können eine oder mehrere, beliebig zusammengesetzte Schichten aus Halbleitermaterial auf der Substratscheibe epitaktisch abgeschieden werden. Im Hinblick auf die bevorzugte Verwendung der resultierenden Halbleiterscheiben sind folgende Schichteigenschaften und Abscheideparameter vorteilhaft:

Gesamtschichtdicke der epitaktisch abgeschiedenen Schichten von 5 bis 200 µm; Dotierstoff-Konzentrationen in den abgeschiedenen Schichten von 1,0∗10¹³ at/cm³ bis 1,0∗10¹⁷ at/cm³; Trichlorsilan, Dichlorsilan oder Silan als Halbleiterquelle für die Abscheidung; Konzentration der Halbleiterquelle in der Gasphase von 0,5 bis 5,0 Vol.%, vorzugsweise 4 Vol.%; Phosphorwasserstoff, Arsenwasserstoff oder Diboran als Dotiergase; Wasserstoff als Trägergas und Chlorwasserstoff als Ätzgas zur Konditionierung der Substratscheibe vor der Abscheidung. Die Abscheidetemperatur beträgt vorzugsweise 850 bis 1170 °C und der Abscheidedruck beträgt vorzugsweise 10⁴-10⁵ Pa (80 bis 760 Torr) besonders bevorzugt Atmosphärendruck. Eine Abscheiderate von 0,5 bis 5 µm/min, bevorzugt 1,0 bis 1,5 µm/min hat sich als günstig erwiesen.

Eine besonders bevorzugte Halbleiterscheibe basiert auf einer mit Phosphor dotierten FZ-Substratscheibe, auf deren Vorderseite mindestens eine Schicht aus dotiertem Silicium epitaktisch abgeschieden ist und auf deren Rückseite sich jeweils eine Schicht aus polykristallinem Silicium und/oder Siliciumdioxid befindet.

## Patentansprüche

1. Verfahren zur Herstellung einer epitaktisch beschichteten Halbleiterscheibe, bestehend aus einer Substratscheibe aus monokristallinem Silicium mit einer Vorder- und einer Rückseite, und mindestens einer Schicht aus Halbleitermaterial, die auf der Vorderseite der Substratscheibe epitaktisch abgeschieden ist, gekennzeichnet durch die folgenden Verfahrensschritte:
a) Herstellen eines stark dotierten Einkristalls aus Silicium durch tiegelfreies Zonenziehen;
b) Herstellen einer Substratscheibe mit polierter Vorderseite aus dem Einkristall;
c) Abscheiden von mindestens einer epitaktischen Schicht aus Halbleitermaterial auf der Vorderseite der Substratscheibe.

2. Verfahren nach Anspruch 1, dadurch gekennzeichnet, daß der Einkristall bei seiner Herstellung mit Phosphor dotiert wird und die Dotierstoff-Konzentration in der Substratscheibe größer als 1,5∗10¹⁸ at/cm³ ist.

3. Verfahren nach Anspruch 1 oder Anspruch 2, dadurch gekennzeichnet, daß der Einkristall bei seiner Herstellung mit Sauerstoff verunreinigt wird, so daß die Sauerstoff-Konzentration in der Substratscheibe 1∗10¹⁶ bis 8∗10¹⁷ at/cm³ ist.

4. Verfahren nach einem der Ansprüche 1 bis 3, dadurch gekennzeichnet, daß die Rückseite der Substratscheibe mit einer Schicht bedeckt wird, die als externer Getter wirkt.

5. Verfahren nach einem der Ansprüche 1 bis 4, dadurch gekennzeichnet, daß auf der Substratscheibe mindestens eine Schicht aus Silicium epitaktisch abgeschieden wird, die mit einem Element aus der 3. oder 5. Hauptgruppe des Periodensystems dotiert ist.

6. Halbleiterscheibe, erhältlich durch ein Verfahren nach einem der Ansprüche 1 bis 5.

7. Verwendung der Halbleiterscheibe nach Anspruch 6 als Grundmaterial zur Herstellung von elektronischen Leistungsschaltern, hochsperrenden Dioden und Schottky-Dioden.

## Claims

1. Process for the production of an epitaxially coated semiconductor wafer, composed of a substrate wafer of monocrystalline silicon having a front side and a rear side, and at least one layer of semiconductor material which is epitaxially deposited on the front side of the substrate wafer, which process is characterized by the following process steps:
a) production of a heavily doped silicon monocrystal by crucible-free zone pulling;
b) production of a substrate wafer having polished front side from the monocrystal;
c) deposition of at least one epitaxial layer of semiconductor material on the front side of the substrate wafer.

2. Process according to Claim 1, characterized in that the monocrystal is doped with phosphorus during its production and the dopant concentration in the substrate wafer is greater than 1.5∗10¹⁸ atoms/cm³.

3. Process according to Claim 1 or 2, characterized in that the monocrystal is contaminated with oxygen during its production, with the result that the oxygen concentration in the substrate wafer is 1∗10¹⁶ to 8∗10¹⁷ atoms/cm³.

4. Process according to any of Claims 1 to 3, characterized in that the rear side of the substrate wafer is covered with a layer which acts as external getter.

5. Process according to any of Claims 1 to 4, characterized in that at least one silicon layer is epitaxially deposited on the substrate wafer, which silicon layer is doped with an element from group III A or V A of the periodic system.

6. Semiconductor wafer which can be obtained by a process according to any of Claims 1 to 5.

7. Use of the semiconductor wafer according to Claim 6 as base material for the production of electronic power switches, high-reverse-voltage diodes and Schottky diodes.

## Revendications

1. Procédé de fabrication d'une plaquette semi-conductrice revêtue par épitaxie, constituée d'une plaquette de substrat en silicium monocristallin comportant une face avant et une face arrière, et d'au moins une couche de matériau semi-conducteur qui est déposée par épitaxie sur la face avant de la plaquette de substrat, caractérisé par les étapes de procédé suivantes :
a) préparation d'un monocristal de silicium à fort dopage par tirage de zone en zone flottante;
b) préparation d'une plaquette de substrat comportant une face avant polie du monocristal;
c) dépôt d'au moins une couche épitaxiale de matériau semi-conducteur sur la face avant de la plaquette de substrat.

2. Procédé suivant la revendication 1, caractérisé en ce que le monocristal est dopé au phosphore pendant sa préparation et en ce que la concentration de matière de dopage dans la plaquette de substrat est supérieure à 1,5∗10¹⁸ atomes/cm³.

3. Procédé suivant la revendication 1 ou 2, caractérisé en ce que le monocristal est contaminé avec de l'oxygène pendant sa préparation, de sorte que la concentration en oxygène dans la plaquette de substrat soit de 1∗10¹⁶ à 8∗10¹⁷ atomes/cm³.

4. Procédé suivant l'une quelconque des revendications 1 à 3, caractérisé en ce que la face arrière de la plaquette de substrat est recouverte d'une couche qui agit comme un getter externe.

5. Procédé suivant l'une quelconque des revendications 1 à 4, caractérisé en ce qu'au moins une couche de silicium est déposée par épitaxie sur la plaquette de substrat, laquelle couche de silicium est dopée avec un élément du groupe III A ou V A du système périodique.

6. Plaquette semi-conductrice pouvant être obtenue par un procédé suivant l'une quelconque des revendications 1 à 5.

7. Utilisation de la plaquette semi-conductrice suivant la revendication 6, comme matériau de base pour la fabrication d'interrupteurs électroniques de puissance, de diodes à haute tension inverse et de diodes Schottky.
